# EUROPEAN PATENT APPLICATION

(11) **EP 4 686 351 A1**
(43) Date of publication of application: **28.01.2026**
(21) Application number: 25185981.5
(22) Date of filing: 27.06.2025
(51) Int. Cl.: H10H 29/39

(54) **DISPLAY DEVICE**

(30) Priority: 22.07.2024 KR 20240096207
(71) Applicant: LG Display Co., Ltd., Seoul, 07336 (KR)
(72) Inventor: RYU, HoJin, 10845 Gyeonggi-do (KR)
(74) Representative: Morrall, Jonathan Ian McLachlan

(57) **Abstract**

A display device includes a display panel including a plurality of sub pixels, each of the plurality of sub pixels including a light emitting diode on a substrate; a passivation layer on the substrate and at least partly covering a lateral side surface of the light emitting diode; and a protection layer on the passivation layer and at least partly covering a lateral side surface of the passivation layer, wherein a lateral end of the passivation layer in a first direction is disposed under the protection layer to form an undercut structure under the protection layer. Accordingly, an undercut structure is formed in a boundary area between the plurality of sub pixels to minimize or suppress a defect of pixel electrodes of the plurality of sub pixels being connected to each other.

## Description

### CROSS-REFERENCE TO RELATED APPLICATIONS

This application claims the priority of Korean Patent Application No. 10-2024-0096207, filed on July 22, 2024, in the Korean Intellectual Property Office, the disclosure of which is incorporated herein by reference.

### BACKGROUND

### Field

The present disclosure relates to a display device and, more particularly, to a display device using a light emitting diode (LED).

### Description of the Related Art

Display devices used for a monitor of a computer, a television, or a cellular phone include, among others, an organic light emitting display device (OLED), which is a self-emitting device, and a liquid crystal display device (LCD), which requires a separate light source.

As applications for display devices are becoming more diversified, for example, from personal digital assistants to monitors of computers and televisions, a display device with a large display area and reduced volume and weight is being studied.

Further, in recent years, a display device including an LED is attracting attention as a next generation display device. Since the LED is formed of an inorganic material, rather than an organic material, its reliability is excellent so that its lifespan is longer than that of the liquid crystal display device or the organic light emitting display device. Further, the LED has a relatively fast lighting speed, excellent luminous efficiency, and a strong impact resistance so that its stability is excellent, and an image having a high luminance may be displayed.

### SUMMARY

An object of the present disclosure is to provide a display device which includes an inorganic light emitting diode with excellent luminous efficiency to be driven at a low power.

Another object of the present disclosure is to provide a display device including a high-resolution inorganic light emitting diode which suppresses a patterning defect of pixel electrodes being connected to each other due to a reduced interval between a plurality of pixel electrodes.

Still another object of the present disclosure is to provide a display device which suppresses a short-circuit defect due to the patterning defect of the plurality of pixel electrodes.

Objects of the present disclosure are not limited to the above-mentioned objects, and other objects, which are not mentioned above, can be clearly understood by those skilled in the art from the following descriptions.

To achieve these objects and other advantages and in accordance with the purpose of the present disclosure, as embodied and broadly described herein, a display device includes a display panel including a plurality of sub pixels; a light emitting diode disposed in each of the plurality of sub pixels; a passivation layer covering, at least partially, a side portion of the light emitting diode; a protection layer disposed on the passivation layer and covering, at least partially, the side portion of the light emitting diode; and a pixel electrode disposed on the light emitting diode and the protection layer, wherein in a boundary area between two adjacent sub pixels in a first direction, among the plurality of sub pixels, a lateral end of the passivation layer is disposed under the protection layer to form an undercut structure under the protection layer. Accordingly, an undercut structure is formed in the boundary area between the plurality of sub pixels to minimize or suppress a potential defect of pixel electrodes of the plurality of sub pixels being connected to each other.

In another example of the present disclosure, a display device includes a substrate; at least one first reflective electrode disposed on the substrate; a plurality of second reflective electrodes on the substrate and spaced apart respectively from the at least one first reflective electrode; a plurality of light emitting diodes disposed respectively on the at least one first reflective electrode; a planarization layer on the at least one first reflective electrode and the second reflective electrodes to cover lower portions of the plurality of light emitting diodes; a plurality of disconnection structures on the planarization layer and disposed respectively at both lateral sides of the plurality of light emitting diodes in a first direction; and a plurality of pixel electrodes on and in contact with the plurality of light emitting diodes, respectively, wherein the plurality of disconnection structures is disposed respectively between the plurality of pixel electrodes in the first direction. Therefore, the plurality of disconnection structures are disposed between the plurality of pixel electrodes so that, if a defect of the plurality of pixel electrodes being connected to each other occurs, the plurality of pixel electrodes could still be separated.

In yet another example of the present disclosure, a display device includes a display panel including a plurality of sub pixels, each of the plurality of sub pixels including a light emitting diode on a substrate; a passivation layer on the substrate and at least partly covering a lateral side surface of the light emitting diode; and a protection layer on the passivation layer and at least partly covering a lateral side surface of the passivation layer, wherein a lateral end of the passivation layer in a first direction is disposed under the protection layer to form an undercut structure under the protection layer.

Other detailed matters of various example embodiments are included in the detailed description and the drawings.

According to example embodiments of the present disclosure, a high-resolution display device which includes an inorganic light emitting diode with excellent luminous efficiency to display an image with a high efficiency and a high luminance at a low power may be implemented.

According to the example embodiments of present disclosure, a disconnection structure is formed between the plurality of pixel electrodes to suppress a defect of the plurality of pixel electrodes being connected to each other.

According to example embodiments of the present disclosure, a disconnection structure is disposed on the border between the plurality of sub pixels to minimize or suppress a short-circuit defect between the plurality of pixel electrodes.

The effects according to the present disclosure are not limited to the contents exemplified above, and various additional effects may be attained from the present disclosure.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a schematic diagram of a display device according to an example embodiment of the present disclosure;
FIG. 2A is a partial cross-sectional view of a display device according to an example embodiment of the present disclosure;
FIG. 2B is a perspective view of a tiling display device according to an example embodiment of the present disclosure;
FIG. 3 is an enlarged plan view of a display device according to an example embodiment of the present disclosure;
FIG. 4 is a cross-sectional view taken along IV-IV' in FIG. 3;
FIG. 5 is a cross-sectional view taken along V-V' in FIG. 3;
FIG. 6 is a cross-sectional view taken along VI-VI' in FIG. 3; and
FIGs. 7A to 7E are process diagrams for explaining a manufacturing process of a display device according to an example embodiment of the present disclosure.

### DETAILED DESCRIPTION

Advantages and characteristics of the present disclosure and a method of achieving the advantages and characteristics will be clear by referring to example embodiments described below in detail together with the accompanying drawings. However, the present disclosure is not limited to the example embodiments disclosed herein and may be implemented in various other forms. The example embodiments are provided by way of example only so that those skilled in the art can fully understand the features and aspects of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure.

Such terms as "including," "having," and "consist of," where used herein, are generally intended to allow other components to be added unless the terms are used with a more limiting term like "only". Any references to singular may include plural, and vice versa, unless expressly stated otherwise.

Components are to be interpreted to include an ordinary error range even if not expressly stated.

Where the position relation between two parts is described using such terms as "on", "above", "below", and "next", one or more parts may be positioned between the two parts unless the terms are used with a more limiting term like "immediately" or "directly".

Where an element or layer is described as being disposed "on" another element or layer, the element or layer may be disposed directly on the other element or layer, or an additional layer or element may be interposed therebetween.

Although the terms "first", "second", and the like may be used for describing various components, these components are not confined by these terms. These terms are merely used to refer to one component separately from the other components. Therefore, a first component to be mentioned below may be a second component, and vice versa, in a technical concept of the present disclosure.

Like reference numerals generally denote like elements throughout the specification unless otherwise specified.

A size and a thickness of each component illustrated in the drawings are illustrated for convenience of description, and the present disclosure is not limited to the size and the thickness of the component illustrated.

The features of various example embodiments of the present disclosure can be partially or entirely adhered to or combined with each other and can be interlocked and operated in technically various ways, and the example embodiments can be carried out independently of or in association with each other.

Hereinafter, example embodiments of the present disclosure will be described in detail with reference to accompanying drawings.

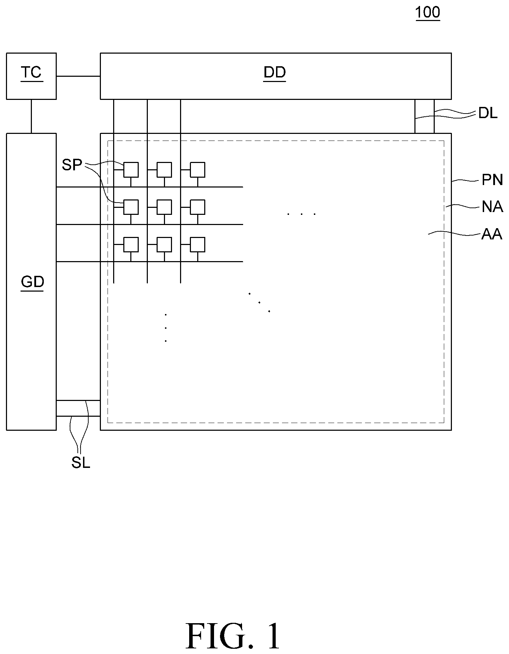

FIG. 1 is a schematic diagram of a display device according to an example embodiment of the present disclosure. In FIG. 1, for the convenience of description, among various components of the display device, only a display panel PN, a gate driver GD, a data driver DD, and a timing controller TC are illustrated.

As shown in FIG. 1, the display device includes a display panel PN including a plurality of sub pixels SP, a gate driver GD and a data driver DD which are configured to supply various signals to the display panel PN, and a timing controller TC which controls the gate driver GD and the data driver DD.

The gate driver GD supplies a plurality of scan signals to a plurality of scan lines SL according to a plurality of gate control signals supplied from the timing controller TC. Even though FIG. 1 illustrates one gate driver GD spaced apart from one side of the display panel PN, the number of the gate drivers GD and the placement thereof are not limited thereto.

The data driver DD supplies a data voltage to a plurality of data lines DL according to a plurality of data control signals and image data supplied from the timing controller TC. The data driver DD may convert the image data into a data voltage using a reference gamma voltage and supply the converted data voltage to the plurality of data lines DL.

The timing controller TC aligns image data input from an external source to supply the image data to the data driver DD. The timing controller TC may generate a gate control signal and a data control signal using synchronization signals input from the external source, such as a dot clock signal, a data enable signal, and horizontal/vertical synchronization signals. The timing controller TC supplies the generated gate control signal and data control signal to the gate driver GD and the data driver DD, respectively, to control the gate driver GD and the data driver DD.

The display panel PN is configured to display images to the user and includes the plurality of sub pixels SP. In the display panel PN, the plurality of scan lines SL and the plurality of data lines DL intersect each other, and the plurality of sub pixels SP may be connected to intersections of the scan lines SL and the data lines DL.

In the display panel PN, an active area AA and a non-active area NA may be defined.

The active area AA is an area in which images are displayed in the display device 100. In the active area AA, a plurality of sub pixels SP configuring a plurality of pixels PX and a pixel circuit for driving the plurality of sub pixels SP may be disposed. The plurality of sub pixels SP is a minimum unit which configures the active area AA, and n sub pixels SP may form one pixel PX, n being an integer. In each of the plurality of sub pixels SP, a thin film transistor for driving the plurality of light emitting elements ED may be disposed. The plurality of light emitting elements ED may be defined in different ways depending on the type of the display panel PN. For example, if the display panel PN is an inorganic light emitting display panel PN, the light emitting element ED may be a light emitting diode (LED) or a micro light emitting diode (micro LED).

In the active area AA, a plurality of signal lines for transmitting various signals to the plurality of sub pixels SP is disposed. For example, the plurality of signal lines may include a plurality of data lines DL for supplying a data voltage to each of the plurality of sub pixels SP and a plurality of scan lines SL for supplying a scan signal to each of the plurality of sub pixels SP. The plurality of scan lines SL extend in one direction in the active area AA to be connected to the plurality of sub pixels SP, and the plurality of data lines DL extend in a direction different from the one direction in the active area AA to be connected to the plurality of sub pixels SP. In addition, in the active area AA, a low potential power line and a high potential power line may be further disposed, but the present disclosure is not limited thereto.

The non-active area NA is an area where images are not displayed so that the non-active area NA may be defined as an area extending from the active area AA. In the non-active area NA, a link line for transmitting a signal to the sub pixel SP of the active area AA, a pad electrode, or a driving IC, such as a gate driver IC or a data driver IC, may be disposed.

Here, the non-active area NA may be located on a rear surface of the display panel PN, that is, a surface opposite to the surface on which the sub pixels SP are disposed, and the present disclosure is not limited to the configuration as illustrated in the drawing.

In another aspect, a driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner.

For example, the data driver DD and the timing controller TC may be formed in separate flexible film and printed circuit board. The display panel PN may be electrically connected to the data driver DD and the timing controller TC by bonding the flexible film and the printed circuit board to the pad electrode formed in the non-active area NA of the display panel PN.

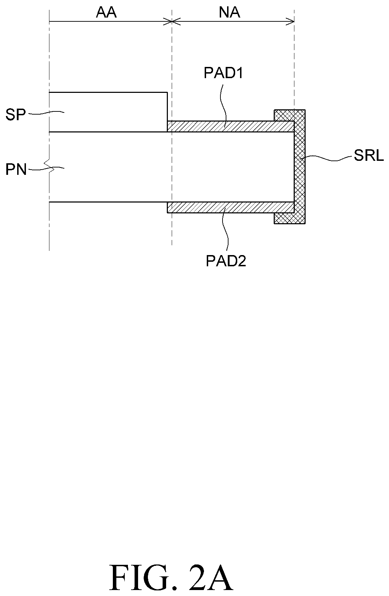

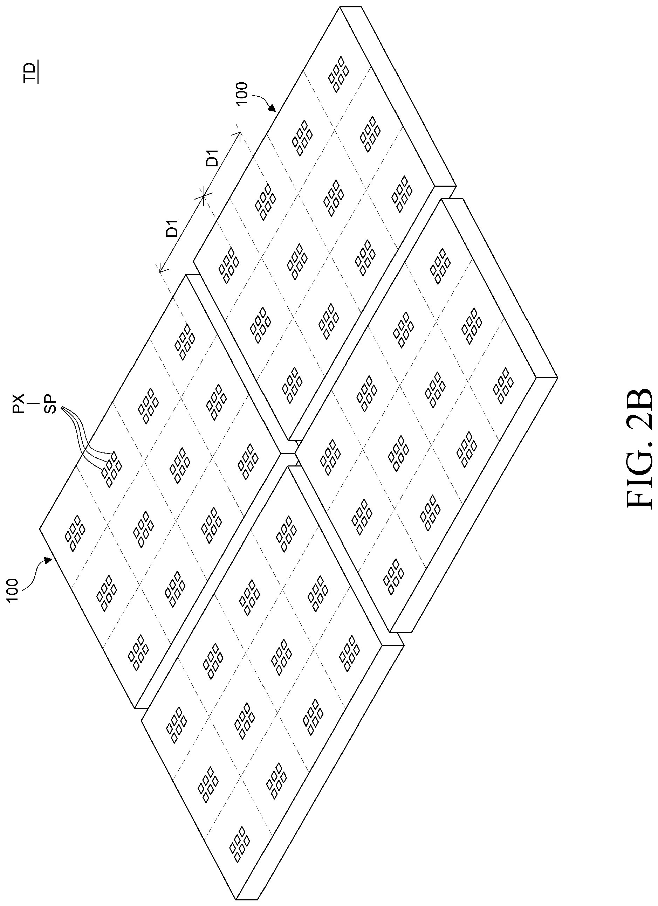

As another example, if the gate driver GD is mounted in the active area AA in the GIA manner and a side line SRL connecting the signal line on the front surface of the display panel PN to the pad electrode on a rear surface of the display panel PN is formed to bond the flexible film and the printed circuit board onto a rear surface of the display panel PN, the non-active area NA on the front surface of the display panel PN may be minimized or reduced. Therefore, if the gate driver GD, the data driver DD, and the timing controller TC are connected to the display panel PN as described above, a zero bezel in which there is no bezel may be substantially implemented. This will be described in more detail with reference to FIGs. 2A and 2B.

FIG. 2A is a partial cross-sectional view of a display device according to an example embodiment of the present disclosure. FIG. 2B is a perspective view of a tiling display device according to an example embodiment of the present disclosure.

In the non-active area NA of the display panel PN, a plurality of pad electrodes for transmitting various signals to the plurality of sub pixels SP are disposed. For example, in a non-active area NA on the front surface of the display panel PN, a first pad electrode PAD1 for transmitting a signal to the plurality of sub pixels SP is disposed. In a non-active area NA on the rear surface of the display panel PN, a second pad electrode PAD2 electrically connected to a driving component, such as a flexible film and the printed circuit board, is disposed.

In this case, even though not illustrated in the drawings, various signal lines connected to the plurality of sub pixels SP, for example, a scan line SL or a data line DL, extend from the active area AA to the non-active area NA to be electrically connected to the first pad electrode PAD1.

The side line SRL is disposed along a side surface of the display panel PN. The side line SRL may electrically connect the first pad electrode PAD1 on the front surface of the display panel PN with the second pad electrode PAD2 on the rear surface of the display panel PN. Therefore, a signal from a driving component on the rear surface of the display panel PN may be transmitted to the plurality of sub pixels SP through the second pad electrode PAD2, the side line SRL, and the first pad electrode PAD1. Accordingly, a signal transmitting path is formed from the front surface of the display panel PN to the side surface and the rear surface of the display panel PN to minimize or reduce an area of the non-active area NA on the front surface of the display panel PN.

As shown in FIG. 2B, a tiling display device TD having a large screen size may be implemented by connecting a plurality of display devices 100. At this time, as illustrated in FIG. 2A, when the tiling display device TD is implemented using a display device 100 with a minimized or reduced bezel, a seam area between the display devices 100 in which an image is not displayed can be minimized or reduced so that a display quality may be improved.

For example, the plurality of sub pixels SP may form one pixel PX and a distance D1 between an outermost pixel PX of one display device 100 and an outermost pixel PX of another display device 100 adjacent to one display device may be implemented to be equal to a distance D1 between two adjacent pixels PX in one display device 100. Accordingly, the interval of the pixels PX even between the display devices 100 can be uniformly configured to minimize or reduce the seam area.

However, FIGs. 2A and 2B are illustrative so that the display device 100 according to an example embodiment of the present disclosure may be a general display device with a bezel but is not limited thereto.

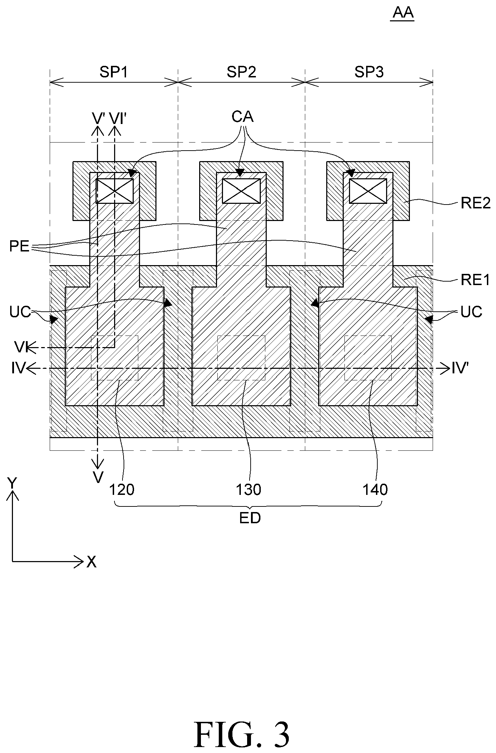

Hereinafter, a sub pixel SP of a display panel PN of a display device 100 according to an example embodiment of the present disclosure will be described in more detail with reference to FIGs. 3 to 6.

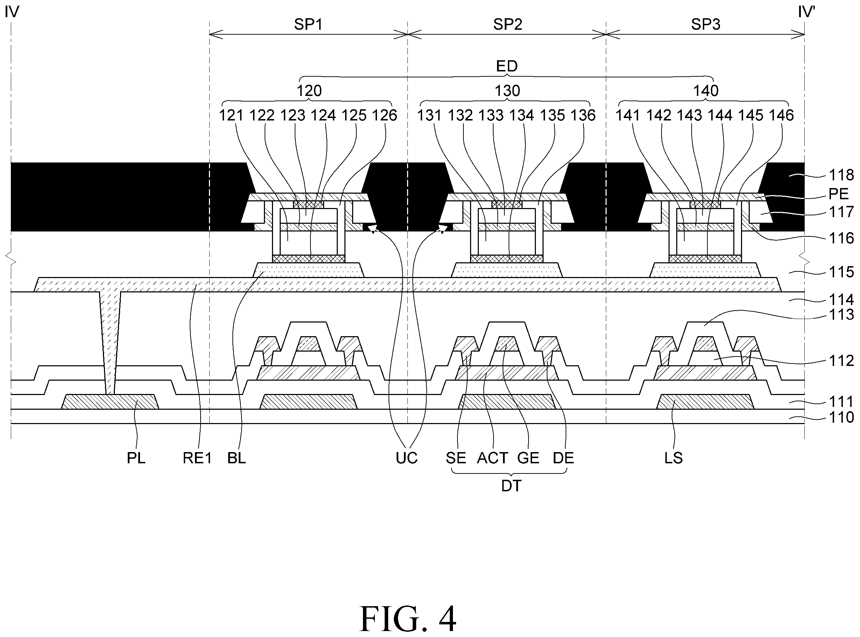

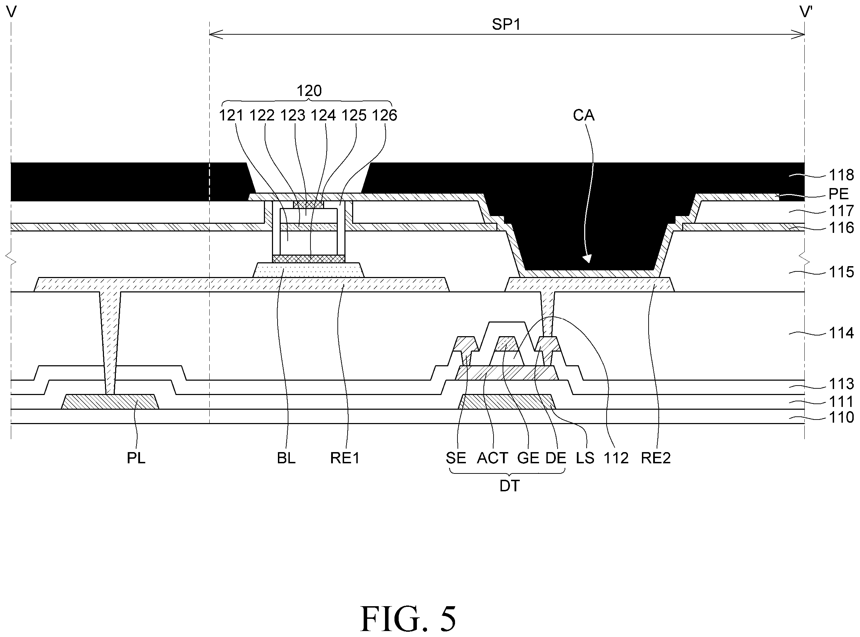

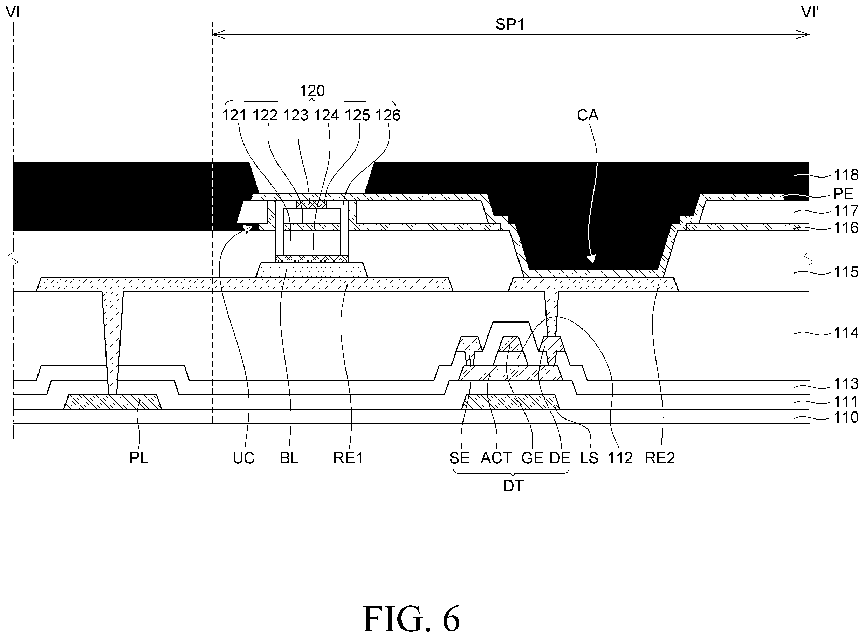

FIG. 3 is an enlarged plan view of a display device according to an example embodiment of the present disclosure. FIG. 4 is a cross-sectional view taken along IV-IV' in FIG. 3. FIG. 5 is a cross-sectional view taken along V-V' in FIG. 3. FIG. 6 is a cross-sectional view taken along VI-VI' in FIG. 3. Specifically, FIG. 3 is a plan view of a plurality of sub pixels SP, FIG. 4 is a cross-sectional view of a plurality of sub pixels SP, and FIGs. 5 and 6 are cross-sectional views of a first sub pixel SP1. In FIG. 3, for the convenience of description, only the plurality of light emitting diodes ED, a plurality of reflective electrodes, and a pixel electrode PE are illustrated.

As illustrated in FIGs. 3 and 4, the plurality of sub pixels SP are disposed in the active area AA. Each of the plurality of sub pixels SP includes a light emitting diode ED and independently emits light. The plurality of sub pixels SP may be disposed in a matrix by forming a plurality of rows and a plurality of columns, but embodiments of the present disclosure are not limited thereto.

The plurality of sub pixels SP may include a first sub pixel SP1, a second sub pixel SP2, and a third sub pixel SP3. For example, any one of the first sub pixel SP1, the second sub pixel SP2, and the third sub pixel SP3 may be a red sub pixel SP, another may be a green sub pixel SP, and the third may be a blue sub pixel SP. The types and the number of the plurality of sub pixels SP here are illustrative, and embodiments of the present disclosure are not limited thereto.

As shown in FIGs. 4 to 6, the substrate 110 may be a member which supports other components of the display device 100 and may be an insulating substrate 110. For example, the substrate 110 may be formed of glass or resin. Further, the substrate 110 may be formed of polymer or plastic, and in some example embodiments, the substrate 110 may be formed of a plastic material having flexibility. A plurality of pixels PX each including a plurality of sub pixels SP are formed on the substrate 110 to display images.

A light shielding layer LS is disposed on the substrate 110 in each of the plurality of sub pixels SP. The light shielding layer LS blocks light which is incident onto the active layer ACT of the driving transistor DT to minimize or reduce a leakage current. For example, the light shielding layer LS is disposed below the active layer ACT of the driving transistor DT to block light incident onto the active layer ACT. If light is irradiated onto the active layer ACT, leakage current may be generated, which may degrade the reliability of the driving transistor DT. Accordingly, the light shielding layer LS configured to block the light is disposed on the substrate 110 to improve the reliability of the driving transistor DT. The light shielding layer LS may be configured by an opaque conductive material such as copper (Cu), aluminum (Al), molybdenum (Mo), nickel (Ni), titanium (Ti), chrome (Cr), or an alloy thereof, but is not limited thereto.

The power line PL is disposed on the substrate 110. The power line PL is disposed to be adjacent to the plurality of sub pixels SP to transmit the power voltage to the light emitting diode ED of the plurality of sub pixels SP. The power line PL may be formed of the same conductive material as the light shielding layer LS. For example, the power line PL may be configured by a conductive material such as copper (Cu), aluminum (Al), molybdenum (Mo), nickel (Ni), titanium (Ti), chrome (Cr), or an alloy thereof, but is not limited thereto. The power line PL may be electrically connected to the plurality of light emitting diodes ED through the first reflective electrode RE1 to be described below. The power line PL may be any one of a high potential power line or a low potential power line according to the configuration of the pixel circuit.

A buffer layer 111 is disposed on the substrate 110, the light shielding layer LS, and the power line PL. The buffer layer 111 is disposed so as to cover one surface of the substrate 110 to reduce permeation of moisture or impurities through the substrate 110. The buffer layer 111 may be configured by a single layer or by multiple layers of silicon oxide (SiOx) and/or silicon nitride (SiNx), but is not limited thereto. The buffer layer 111 may be omitted depending on a type of substrate 110 or a type of transistor employed, but embodiments of the present disclosure are not limited thereto.

Here, even though not illustrated in the drawings, an additional buffer layer may be further disposed between the substrate 110 and the light shielding layer LS. The additional buffer layer may be disposed so as to reduce permeation of the moisture or impurities through the substrate 110, to be the same as the above-described buffer layer 111. For example, the additional buffer layer may be configured by a single layer or by multiple layers of silicon oxide (SiOx) and/or silicon nitride (SiNx), but embodiments of the present disclosure are not limited thereto.

Next, a driving transistor DT is disposed on the buffer layer 111 in each of the plurality of sub pixels SP. The driving transistor DT includes an active layer ACT, a gate electrode GE, a source electrode SE, and a drain electrode DE. Here, even though not illustrated in the drawings, in each of the plurality of sub pixels SP, other components, such as a switching transistor, a sensing transistor, an emission control transistor, and a storage capacitor may be disposed, in addition to the driving transistor DT.

The active layer ACT of the driving transistor DT is disposed on the buffer layer 111. The active layer ACT may be disposed so as to overlap the light shielding layer LS. The active layer ACT may be formed of a semiconductor material, such as an oxide semiconductor, amorphous silicon, or polysilicon, but is not limited thereto. Further, even though not illustrated in the drawings, active layers ACT of other transistors, such as a switching transistor, a sensing transistor, and an emission control transistor, may also be formed of a semiconductor material, such as an oxide semiconductor, amorphous silicon, or polysilicon, but are not limited thereto. The active layers ACT of the driving transistor DT, the switching transistor, the sensing transistor, and the emission control transistor may be formed of the same material or be formed of different materials.

The gate insulating layer 112 is disposed on the active layer ACT. The gate insulating layer 112 is an insulating layer for insulating the active layer ACT from the gate electrode GE. For example, the gate insulating layer 112 may be configured by a single layer or by multiple layers of silicon oxide (SiOx) and/or silicon nitride (SiNx), but is not limited thereto. Here, even though the drawing illustrates the gate insulating layer 112 being disposed only below the gate electrode GE, the gate insulating layer 112 is not limited thereto and may be disposed on a larger area of the front surface of the substrate 110.

The gate electrode GE is disposed on the gate insulating layer 112. The gate electrode GE may be disposed so as to overlap the active layer ACT. The gate electrode GE may be configured by a conductive material, such as copper (Cu), aluminum (Al), molybdenum (Mo), nickel (Ni), titanium (Ti), chrome (Cr), or an alloy thereof, but is not limited thereto.

The interlayer insulating layer 113 is disposed on the gate electrode GE. In the interlayer insulating layer 113, a contact hole through which the source electrode SE and the drain electrode DE are connected to the active layer ACT is formed. The interlayer insulating layer 113 is an insulating layer which protects components below the interlayer insulating layer 113 and may be configured by a single layer or by multiple layers of silicon oxide (SiOx) and/or silicon nitride (SiNx), but is not limited thereto.

The source electrode SE and the drain electrode DE are disposed on the interlayer insulating layer 113. The source electrode SE and the drain electrode SE may be electrically connected to the active layer ACT through respective contact holes formed in the interlayer insulating layer 113. The source electrode SE may be electrically connected to the light shielding layer LS through the intermediate electrode (not illustrated), and the drain electrode DE may be electrically connected to the light emitting diode ED through a second reflective electrode RE2 to be described below. The source electrode SE and the drain electrode DE may be configured by a conductive material, such as copper (Cu), aluminum (Al), molybdenum (Mo), nickel (Ni), titanium (Ti), chrome (Cr), or an alloy thereof, but are not limited thereto.

Next, the first planarization layer 114 is disposed on the driving transistor DT and the interlayer insulating layer 113. The first planarization layer 114 may planarize an upper portion of the pixel circuit including the driving transistor DT. The first planarization layer 114 may be configured by a single layer or by multiple layers. For example, the first planarization layer 114 may be configured by benzocyclobutene or an acrylic organic material, but is not limited thereto.

In the meantime, even though not illustrated in the drawings, a separate insulating layer may be further disposed between the first planarization layer 114 and the interlayer insulating layer 113. For example, the additional insulating layer may be configured by a single layer or by multiple layers of an inorganic material, such as silicon oxide (SiOx) or silicon nitride (SiNx), but is not limited thereto.

Next, a plurality of reflective electrodes are disposed on the first planarization layer 114. The plurality of reflective electrodes may serve as an electrode which reflects light emitted from the plurality of light emitting diodes ED toward the top away from the substrate 110 in the illustrated cross-sectional views and electrically connect the driving transistor DT and the power line PL with the plurality of light emitting diodes ED. The plurality of reflective electrodes may include a plurality of first reflective electrodes RE1 and a second reflective electrode RE2.

As illustrated in FIGs. 3 and 4, the first reflective electrode RE1 is disposed on the first planarization layer 114 in each of the plurality of sub pixels SP. The first reflective electrode RE1 may be used as an electrode which reflects light emitted from the plurality of light emitting diodes ED toward the top away from the substrate 110 in the illustrated cross-sectional views and electrically connect the plurality of light emitting diodes ED and the power line PL with each other. For example, the first reflective electrode RE1 may be electrically connected to the power line PL through contact holes in the first planarization layer 114, the interlayer insulating layer 113, and the buffer layer 111. The first reflective electrode RE1 may also be electrically connected to n-type electrodes or p-type electrodes of the plurality of light emitting diodes ED.

The same power voltage may be applied to the first reflective electrode RE1 in each of the plurality of sub pixels SP from the power line PL. Therefore, the first reflective electrodes RE1 of the plurality of sub pixels SP may be connected to each other. In this case, at least some sub pixels SP, among the plurality of sub pixels SP, may share the same first reflective electrode RE1. For example, one first reflective electrode RE1 may be disposed in the plurality of sub pixels SP disposed on the same row. Therefore, the first reflective electrodes RE1 in the plurality of sub pixels SP may be connected to each other so that there is no need to separately connect the first reflective electrode RE1 of each of the plurality of sub pixels SP to the power line PL, and the structure of the sub pixel SP may be simplified. However, embodiments of the present disclosure are not limited thereto, and the first reflective electrodes RE1 of the plurality of sub pixels SP may be disposed to be separated from each other.

As shown in FIGs. 3, 5, and 6, the second reflective electrode RE2 is disposed on the first planarization layer 114 in each of the plurality of sub pixels SP. The second reflective electrode RE2 may be used as an electrode which electrically connects the plurality of light emitting diodes ED and the driving transistor DT with each other. For example, the second reflective electrode RE2 may be electrically connected to the drain electrode DE of the driving transistor DT through a contact hole formed in the first planarization layer 114. The second reflective electrode RE2 may also be electrically connected to p-type electrodes or n-type electrodes of the plurality of light emitting diodes ED.

Accordingly, the plurality of reflective electrodes may include various conductive layers in consideration of a light reflection efficiency and a resistance. For example, the plurality of reflective electrodes may use an opaque conductive layer, such as silver (Ag), aluminum (Al), molybdenum (Mo), titanium (Ti), or an alloy thereof, and a transparent conductive layer, such as indium tin oxide (ITO), but the structure of the plurality of reflective electrodes is not limited thereto.

Next, a bonding layer BL is disposed on the first reflective electrode RE1 in each of the plurality of sub pixels SP. The bonding layer BL may be a conductive adhesion member which electrically connects the light emitting diode ED and the first reflective electrode RE1 with each other while fixing the light emitting diodes ED, 120, 130, and 140 onto the first reflective electrode RE1. The bonding layer BL may have conductivity to electrically connect the first reflective electrode RE1 with the plurality of light emitting diodes ED. The bonding layer BL may have adhesiveness to fix the plurality of light emitting diodes ED to the first reflective electrode RE1. For example, the bonding layer BL may be formed of a material including conductive particles, such as indium, but is not limited thereto and may be an organic layer including conductive particles, such as carbon. In this case, the bonding layer BL may be formed of a material on which the photolithography process may be performed, and a thickness or a placement area of the bonding layer BL may be easily controlled by the photolithography process.

The plurality of light emitting diodes ED are disposed on the bonding layer BL in each of the plurality of sub pixels SP. The plurality of light emitting diodes ED may be any one of a light-emitting diode (LED) and a micro light-emitting diode (micro LED), but embodiments of the present disclosure are not limited thereto. The plurality of light emitting diodes ED are disposed on the bonding layer BL and may be electrically connected to the first reflective electrode RE1 and the power line PL. Accordingly, the light emitting diode ED is applied with a power voltage from the power line PL to emit light.

The plurality of light emitting diodes ED may include a first light emitting diode 120, a second light emitting diode 130, and a third light emitting diode 140. The first light emitting diode 120 may be disposed in the first sub pixel SP1. The second light emitting diode 130 may be disposed in the second sub pixel SP2. The third light emitting diode 140 may be disposed in the third sub pixel SP3. For example, any one of the first light emitting diode 120, the second light emitting diode 130, and the third light emitting diode 140 may be a red light emitting diode ED, another may be a green light emitting diode ED, and the third may be a blue light emitting diode ED. Therefore, red light, green light, and blue light emitted from the plurality of light emitting diodes ED may be combined to implement various color light including white. The types and number of the plurality of light emitting diodes ED here are illustrative, and embodiments of the present disclosure are not limited thereto.

The first light emitting diode 120 is disposed on the bonding layer BL in the first sub pixel SP1. The first light emitting diode 120 includes a first n-type semiconductor layer 121, a first emission layer 122, a first p-type semiconductor layer 123, a first n-type electrode 124, a first p-type electrode 125, and a first protection film 126.

The first n-type semiconductor layer 121 is disposed on the bonding layer BL, and the first p-type semiconductor layer 123 is disposed on the first n-type semiconductor layer 121. The first n-type semiconductor layer 121 and the first p-type semiconductor layer 123 may be layers formed by doping n-type and p-type impurities, respectively, into a specific material. For example, the first n-type semiconductor layer 121 and the first p-type semiconductor layer 123 may be layers doped with n-type or p-type impurities into a material, such as gallium nitride (GaN), indium aluminum phosphide (InAlP), or gallium arsenide (GaAs). The n-type impurity may be silicon (Si), germanium (Ge), or tin (Sn), and the p-type impurity may be magnesium (Mg), zinc (Zn), or beryllium (Be), but embodiments of the present disclosure are not limited thereto.

The first emission layer 122 is disposed between the first n-type semiconductor layer 121 and the first p-type semiconductor layer 123. The first emission layer 122 is supplied with holes and electrons from the first p-type semiconductor layer 123 and the first n-type semiconductor layer 121 to emit light. The first emission layer 122 may be formed with a single layer or a multi-quantum well (MQW) structure. For example, the first emission layer 122 may be formed of indium gallium nitride (InGaN) or gallium nitride (GaN), but is not limited thereto.

The first n-type electrode 124 is disposed on a bottom surface of the first n-type semiconductor layer 121. The first n-type electrode 124 may be in contact with the bonding layer BL. The first n-type electrode 124 may be electrically connected to the first reflective electrode RE1 through the bonding layer BL. Therefore, the first n-type semiconductor layer 121 may be electrically connected to the power line PL through the first n-type electrode 124, the bonding layer BL, and the first reflective electrode RE1. The first n-type electrode 124 may be configured by an opaque conductive material having a high reflection efficiency, such as titanium (Ti), gold (Au), silver (Ag), copper (Cu) or an alloy thereof, and/or a transparent conductive material, such as indium tin oxide (ITO) or indium zinc oxide (IZO), but is not limited thereto.

The first p-type electrode 125 is disposed on a top surface of the first p-type semiconductor layer 123. The first p-type electrode 125 may be disposed so as to cover at least a part of the top surface of the first p-type semiconductor layer 123. The first p-type semiconductor layer 123 may be electrically connected to the pixel electrode PE and the driving transistor DT through the first p-type electrode 125. The first p-type electrode 125 may be formed of a transparent conductive material to transmit light emitted from the first emission layer 122 of the first light emitting diode 120 toward the top of the first light emitting diode 120. For example, the first p-type electrode 125 may be formed of a transparent conductive material, such as indium tin oxide (ITO) or indium zinc oxide (IZO), but is not limited thereto.

The first protection film 126 is disposed so as to enclose the first n-type semiconductor layer 121, the first emission layer 122, and the first p-type semiconductor layer 123. The first protection film 126 is formed of an insulating material to protect the first n-type semiconductor layer 121, the first emission layer 122, and the first p-type semiconductor layer 123. The first protection film 126 covers a side surface of the first n-type semiconductor layer 121, a side surface of the first emission layer 122, a side surface of the first p-type semiconductor layer 123, and a part of a top surface of the first p-type semiconductor layer 123. Here, the first p-type electrode 125 is exposed from the first protection film 126 to be in contact with the pixel electrode PE. Therefore, the first protection film 126, which covers at least a part of the first n-type semiconductor layer 121, the first emission layer 122, and the first p-type semiconductor layer 123, is formed to suppress a short-circuit defect and minimize or suppress a damage to the first light emitting diode 120. The first protection film 126 may be formed of any one of silicon oxide (SiOx) or silicon nitride (SiNx) based material or a resin, but is not limited thereto.

The second light emitting diode 130 is disposed on the bonding layer BL in the second sub pixel SP2. The second light emitting diode 130 includes a second n-type semiconductor layer 131, a second emission layer 132, a second p-type semiconductor layer 133, a second n-type electrode 134, a second p-type electrode 135, and a second protection film 136.

The second n-type semiconductor layer 131 is disposed on the bonding layer BL, and the second p-type semiconductor layer 133 is disposed on the second n-type semiconductor layer 131. The second n-type semiconductor layer 131 and the second p-type semiconductor layer 133 may be layers formed by doping n-type and p-type impurities, respectively, into a specific material. For example, the second n-type semiconductor layer 131 and the second p-type semiconductor layer 133 may be layers doped with n-type or p-type impurities into a material, such as gallium nitride (GaN), indium aluminum phosphide (InAlP), or gallium arsenide (GaAs). The n-type impurity may be silicon (Si), germanium (Ge), or tin (Sn), and the p-type impurity may be magnesium (Mg), zinc (Zn), or beryllium (Be), but are not limited thereto.

The second emission layer 132 is disposed between the second n-type semiconductor layer 131 and the second p-type semiconductor layer 133. The second emission layer 132 is supplied with holes and electrons from the second p-type semiconductor layer 133 and the second n-type semiconductor layer 131 to emit light. The second emission layer 132 may be formed by a single layer or a multi-quantum well (MQW) structure. For example, the second emission layer 132 may be formed of indium gallium nitride (InGaN) or gallium nitride (GaN), but is not limited thereto.

The second n-type electrode 134 is disposed on a bottom surface of the second n-type semiconductor layer 131. The second n-type electrode 134 may be in contact with the bonding layer BL. The second n-type electrode 134 may be electrically connected to the first reflective electrode RE1 through the bonding layer BL. Therefore, the second n-type semiconductor layer 131 may be electrically connected to the power line PL through the second n-type electrode 134, the bonding layer BL, and the first reflective electrode RE1. The second n-type electrode 134 may be configured by an opaque conductive material having a high reflection efficiency, such as titanium (Ti), gold (Au), silver (Ag), copper (Cu) or an alloy thereof, and/or a transparent conductive material, such as indium tin oxide (ITO) or indium zinc oxide (IZO), but is not limited thereto.

The second p-type electrode 135 is disposed on a top surface of the second p-type semiconductor layer 133. The second p-type electrode 135 may be disposed so as to cover at least a part of the top surface of the second p-type semiconductor layer 133. The second p-type semiconductor layer 133 may be electrically connected to the pixel electrode PE and the driving transistor DT through the second p-type electrode 135. The second p-type electrode 135 may be formed of a transparent conductive material to transmit light emitted from the second emission layer 132 of the second light emitting diode 130 toward the top of the second light emitting diode 130. For example, the second p-type electrode 135 may be formed of a transparent conductive material, such as indium tin oxide (ITO) or indium zinc oxide (IZO), but is not limited thereto.

The second protection film 136 is disposed so as to enclose the second n-type semiconductor layer 131, the second emission layer 132, and the second p-type semiconductor layer 133. The second protection film 136 is formed of an insulating material to protect the second n-type semiconductor layer 131, the second emission layer 132, and the second p-type semiconductor layer 133. The second protection film 136 covers a side surface of the second n-type semiconductor layer 131, a side surface of the second emission layer 132, a side surface of the second p-type semiconductor layer 133, and a part of a top surface of the second p-type semiconductor layer 133. Here, the second p-type electrode 135 is exposed from the second protection film 136 to be in contact with the pixel electrode PE. Therefore, the second protection film 136, which covers at least a part of the second n-type semiconductor layer 131, the second emission layer 132, and the second p-type semiconductor layer 133, is formed to suppress a short-circuit defect and minimize or suppress a damage to the second light emitting diode 130. The second protection film 136 may be formed of any one of silicon oxide (SiOx) or silicon nitride (SiNx) based material or a resin, but is not limited thereto.

The third light emitting diode 140 is disposed on the bonding layer BL in the third sub pixel SP3. The third light emitting diode 140 includes a third n-type semiconductor layer 141, a third emission layer 142, a third p-type semiconductor layer 143, a third n-type electrode 144, a third p-type electrode 145, and a third protection film 146.

The third n-type semiconductor layer 141 is disposed on the bonding layer BL, and the third p-type semiconductor layer 143 is disposed on the third n-type semiconductor layer 141. The third n-type semiconductor layer 141 and the third p-type semiconductor layer 143 may be layers formed by doping n-type and p-type impurities, respectively, into a specific material. For example, the third n-type semiconductor layer 141 and the third p-type semiconductor layer 143 may be layers doped with n-type or p-type impurities into a material, such as gallium nitride (GaN), indium aluminum phosphide (InAlP), or gallium arsenide (GaAs). The n-type impurity may be silicon (Si), germanium (Ge), or tin (Sn), and the p-type impurity may be magnesium (Mg), zinc (Zn), or beryllium (Be), but are not limited thereto.

The third emission layer 142 is disposed between the third n-type semiconductor layer 141 and the third p-type semiconductor layer 143. The third emission layer 142 is supplied with holes and electrons from the third p-type semiconductor layer 143 and the third n-type semiconductor layer 141 to emit light. The third emission layer 142 may be formed by a single layer or a multi-quantum well (MQW) structure. For example, the third emission layer 142 may be formed of indium gallium nitride (InGaN) or gallium nitride (GaN), but is not limited thereto.

The third n-type electrode 144 is disposed on a bottom surface of the third n-type semiconductor layer 141. The third n-type electrode 144 may be in contact with the bonding layer BL. The third n-type electrode 144 may be electrically connected to the first reflective electrode RE1 through the bonding layer BL. Therefore, the third n-type semiconductor layer 141 may be electrically connected to the power line PL through the third n-type electrode 144, the bonding layer BL, and the first reflective electrode RE1. The third n-type electrode 144 may be configured by an opaque conductive material having a high reflection efficiency, such as titanium (Ti), gold (Au), silver (Ag), copper (Cu) or an alloy thereof, and/or a transparent conductive material, such as indium tin oxide (ITO) or indium zinc oxide (IZO), but is not limited thereto.

The third p-type electrode 145 is disposed on a top surface of the third p-type semiconductor layer 143. The third p-type electrode 145 may be disposed so as to cover at least a part of the top surface of the third p-type semiconductor layer 143. The third p-type semiconductor layer 143 may be electrically connected to the pixel electrode PE and the driving transistor DT through the third p-type electrode 145. The third p-type electrode 145 may be formed of a transparent conductive material to transmit light emitted from the third emission layer 142 of the third light emitting diode 140 toward the top of the third light emitting diode 140. For example, the third p-type electrode 145 is formed of a transparent conductive material, such as indium tin oxide (ITO) or indium zinc oxide (IZO), but is not limited thereto.

The third protection film 146 is disposed so as to enclose the third n-type semiconductor layer 141, the third emission layer 142, and the third p-type semiconductor layer 143. The third protection film 146 is formed of an insulating material to protect the third n-type semiconductor layer 141, the third emission layer 142, and the third p-type semiconductor layer 143. The third protection film 146 covers a side surface of the third n-type semiconductor layer 141, a side surface of the third emission layer 142, a side surface of the third p-type semiconductor layer 143, and a part of a top surface of the third p-type semiconductor layer 143. Here, the third p-type electrode 145 is exposed from the third protection film 146 to be in contact with the pixel electrode PE. Therefore, the third protection film 146, which covers at least a part of the third n-type semiconductor layer 141, the third emission layer 142, and the third p-type semiconductor layer 143, is formed to suppress a short-circuit defect and minimize or suppress a damage to the third light emitting diode 140. The third protection film 146 may be formed of any one of silicon oxide (SiOx) or silicon nitride (SiNx) based material or a resin, but is not limited thereto.

The second planarization layer 115 is disposed on the plurality of bonding layers BL and the first reflective electrode RE1. The second planarization layer 115 may planarize an upper portion of the substrate 110 on which the plurality of light emitting diodes ED is disposed. The second planarization layer 115 may be disposed so as to cover at least a part of the plurality of light emitting diodes ED. For example, the second planarization layer 115 may be disposed so as to enclose a lower portion of the plurality of light emitting diodes ED, and an upper portion of the plurality of light emitting diodes ED may be exposed from the second planarization layer 115. The second planarization layer 115 may be disposed so as to enclose side surfaces of the n-type electrodes (124, 134, 144) of the plurality of light emitting diodes ED and a side surface of the protection film (126, 136, 146) while covering the bonding layer BL and the first reflective electrode RE1. In this case, a potential defect of the pixel electrode PE being connected to the first n-type semiconductor layer 121, the bonding layer BL, and the first reflective electrode RE1 may be suppressed. The second planarization layer 115 may be configured by a single layer or by multiple layers. For example, the second planarization layer 115 may be configured by benzocyclobutene or an acrylic organic material, but is not limited thereto.

As illustrated in FIGs. 4 to 6, the passivation layer 116 is disposed on the second planarization layer 115. The passivation layer 116 may be disposed so as to enclose an upper side portion of the light emitting diode ED. The passivation layer 116 may be disposed so as to cover a part of a top surface of the second planarization layer 115 and a side portion of the light emitting diode ED disposed above the second planarization layer 115. For example, the passivation layer 116 is formed of any one of silicon oxide (SiOx) or silicon nitride (SiNx) based material or a resin, but is not limited thereto.

As shown in FIG. 4, the passivation layer 116 may be not disposed in at least a part of an area between the plurality of sub pixels SP. During a formation process of the passivation layer 116, a part of the passivation layer 116 may be removed from an area between the plurality of sub pixels SP. For example, the passivation layer 116 may be not disposed in an area between the plurality of sub pixels SP which is an area between the plurality of pixel electrodes PE. For example, with reference to FIGs. 3 and 4, if the plurality of sub pixels SP and the plurality of pixel electrodes PE are disposed along the X direction, the passivation layer 116 in both side areas of the plurality of sub pixels SP, which are boundary areas between the plurality of pixel electrodes PE in the X direction, may be partially removed. Therefore, in the area between the plurality of sub pixels SP, the second planarization layer 115 may be exposed from the passivation layer 116.

As illustrated in FIG. 5, the passivation layer 116 may be disposed so as to overlap the pixel electrode PE in a remaining area excluding a contact area CA in one sub pixel SP. For example, the passivation layer 116 may be disposed below the pixel electrode PE disposed in the first sub pixel SP1, and a contact hole through which the second reflective electrode RE2 is exposed may be formed in the passivation layer 116 in only the contact area CA.

Next, the protection layer 117 is disposed on the passivation layer 116. The protection layer 117 may be disposed so as to cover the passivation layer 116. Here, the p-type electrodes (125, 135, 145) of the plurality of light emitting diodes ED may be exposed from the protection layer 117. A top surface of the protection layer 117 may be disposed at the same height as a top surface of the light emitting diode ED or disposed to be lower than the top surface of the light emitting diode ED. The protection layer 117 may be configured by a single layer or by multiple layers. For example, the protection layer 117 may be configured by benzocyclobutene or an acrylic organic material, but is not limited thereto.

As shown in FIG. 4, the protection layer 117 may be not disposed in at least a part of an area between the plurality of sub pixels SP. During a formation process of the protection layer 117, a part of the protection layer 117 formed in an area between the plurality of sub pixels SP may be removed. For example, the protection layer 117 may be not disposed in an area between the plurality of which pixel electrodes PE, which is an area between the plurality of sub pixels SP. For example, if the plurality of sub pixels SP and the plurality of pixel electrodes PE are disposed along the X direction, the protection layer 117 in both side areas of the plurality of pixel electrodes PE, which are boundary areas between the plurality of sub pixels SP in the X direction, may be partially removed. Therefore, in the area between the plurality of sub pixels SP, the second planarization layer 115 may be exposed from the protection layer 117 and the passivation layer 116.

In a part in which the second planarization layer 115 is exposed, the passivation layer 116 below the protection layer 117 is partially removed so that the passivation layer 116 and the protection layer 117 may form an undercut structure. For example, in the area between the plurality of sub pixels SP in which the passivation layer 116 and the protection layer 117 are partially removed, a lateral end portion of the passivation layer 116 is not as aligned with a lateral end portion of the protection layer 117, but is disposed under the protection layer 117. Therefore, an undercut structure UC may be formed between the lateral end portion of the passivation layer 116 and the protection layer 117. The lateral end portion of the passivation layer 116 in the area between the plurality of sub pixels SP may be disposed farther inside toward the middle of the corresponding sub pixel SP than the lateral end portion of the protection layer 117. The lateral end portion of the protection layer 117 in the area between the plurality of sub pixels SP may protrude from the lateral end portion of the passivation layer 116. In the area between the plurality of sub pixels SP in which the passivation layer 116 and the protection layer 117 are partially removed, the lateral end portion of the passivation layer 116 may be disposed to be closer to the corresponding light emitting diode ED than the lateral end portion of the protection layer 117 is.

The plurality of pixel electrodes PE may be disposed to be separated from each other with respect to the undercut structure UC. The undercut structure UC may be formed in at least a part of the area between the plurality of pixel electrodes PE. Even though a pattering defect of the plurality of pixel electrodes PE occurs, the pixel electrode PE may be separated by the undercut structure UC. Therefore, the passivation layer 116 and the protection layer 117 which form the undercut structure UC may be defined as a disconnection structure, and the disconnection structure may be formed on both side surfaces of each of the plurality of light emitting diodes ED. For example, where the plurality of sub pixels SP is disposed along the X direction, the disconnection structure may be formed on both side surfaces of each of the plurality of light emitting diodes ED in the X direction. As another example, a plurality of disconnection structures may be disposed in the area between the plurality of pixel electrodes PE.

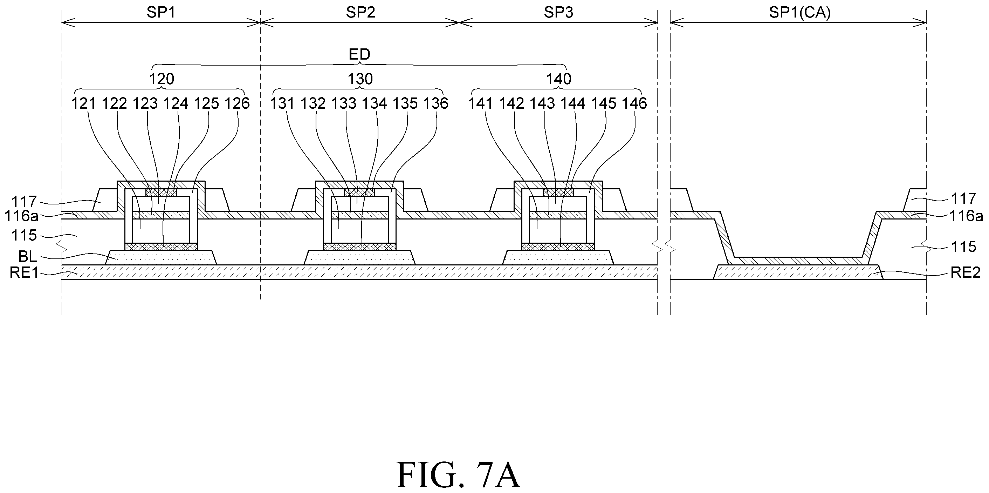

As illustrated in FIG. 5, the undercut structure UC is not formed between the contact area CA and the light emitting diode ED in a corresponding sub pixel SP to suppress disconnection of the pixel electrode PE disposed between the contact area CA and the light emitting diode ED. The pixel electrode PE and the undercut structure UC may extend in the same direction and may be disposed to be parallel to each other, as shown for example in FIGs. 4 and 6. The pixel electrode PE of each of the plurality of sub pixels SP may be disposed in an area between the plurality of undercut structures UC. The undercut structure UC may suppress a patterning defect of the plurality of pixel electrodes PE and a short-circuit defect caused thereby, which will be described below in more detail with reference to FIGs. 7A to 7E.

Next, in each of the plurality of sub pixels SP, the pixel electrode PE is disposed on the light emitting diode ED and the protection layer 117. One end portion of the pixel electrode PE may be in contact with the p-type electrode (e.g., 125) of the light emitting diode ED while covering the light emitting diode ED. In each of the plurality of sub pixels SP, a contact area CA, in which the pixel electrode PE is in contact with the second reflective electrode RE2, is formed. The other end portion of the pixel electrode PE may be disposed in the contact area CA and may be electrically connected to the second reflective electrode RE2 through a contact hole in the protection layer 117, the passivation layer 116, and the second planarization layer 115. Accordingly, the p-type electrode (e.g., 125) and the p-type semiconductor layer (e.g., 123) of the light emitting diode ED may be electrically connected to the second reflective electrode RE2 and the driving transistor DT through the pixel electrode PE. For example, the pixel electrode PE may be configured by a transparent conductive material, such as indium tin oxide (ITO) or indium zinc oxide (IZO), so as to transmit light emitted from the light emitting diode ED toward the top away from the substrate 110 in the illustrated cross-sectional views, but is not limited thereto.

As shown in FIG. 3, the plurality of pixel electrodes PE may extend from the contact area CA toward the light emitting diode ED and have a larger width in an area adjacent to the light emitting diode ED, for example, in an area on the first reflective electrode RE1. A width of the pixel electrode PE in an area between the first reflective electrode RE1 and the second reflective electrode RE2 may be smaller than a width of the pixel electrode PE in an area in which the first reflective electrode RE1 and the light emitting diode ED are disposed. Therefore, in the area in which the light emitting diode ED is disposed, the interval between the plurality of pixel electrodes PE may be narrower than an interval between the plurality of pixel electrodes PE in an area between the first reflective electrode RE1 and the second reflective electrode RE2.

The undercut structure UC may be formed in at least a part of the area between the plurality of pixel electrodes PE, for example, in an area in which the interval between the plurality of pixel electrodes PE is relatively small. For example, the undercut structure UC may be formed between the plurality of pixel electrodes PE in the area on the first reflective electrode RE1 in which the interval between the plurality of pixel electrodes PE is relatively small. However, the undercut structure UC is not limited thereto and may be formed in the entire area between the plurality of pixel electrodes PE.

The bank 118 is disposed on the plurality of pixel electrodes PE and the protection layer 117. The bank 118 is disposed in an area between the plurality of sub pixels SP to minimize or suppress the color mixture between the plurality of sub pixels SP. The bank 118 may be formed of an insulating material. The bank 118 includes a black material to cover wiring lines which may otherwise be visible through the active area AA. For example, the bank 118 may be formed of a carbon-based mixture and, specifically, may include carbon black. However, the bank 118 is not limited thereto and may be formed of another opaque material.

Hereinafter, a formation process of an undercut structure UC and a pixel electrode PE of a display device 100 according to an example embodiment of the present disclosure will be described with reference to FIGs. 7A to 7E.

FIGs. 7A to 7E are process diagrams for explaining a manufacturing process of a display device according to an example embodiment of the present disclosure. FIGs. 7A to 7E are schematic cross-sectional views of the plurality of sub pixels SP for explaining a formation process of an undercut structure UC and a pixel electrode PE. In FIGs. 7A to 7E, for the convenience of description, a configuration below the first reflective electrode RE1 and the second reflective electrode RE2 is not illustrated.

As illustrated in FIG. 7A, an initial passivation layer 116a is formed on a front surface of the display panel PN on which components up to the first reflective electrode RE1, the second reflective electrode RE2, the light emitting diode ED, and the second planarization layer 115 have been formed. The protection layer 117 is formed on the initial passivation layer 116a.

Specifically, the first reflective electrode RE1 and the second reflective electrode RE2 are formed, and the plurality of light emitting diodes ED may be transferred onto the first reflective electrode RE1. Next, on the substrate 110 on which the plurality of light emitting diodes ED, the first reflective electrode RE1, and the second reflective electrode RE2 are formed, the second planarization layer 115 is formed. A contact hole may be formed in the second planarization layer 115 in the contact area CA for the connection between the pixel electrode PE and the second reflective electrode RE2 to be formed in a subsequent process.

Next, the initial passivation layer 116a may be formed on the front surface (or the upper surface in the cross-sectional views) of the substrate 110. The initial passivation layer 116a may cover a top surface of the second planarization layer 115, an upper portion of the light emitting diode ED, and the second reflective electrode RE2.

Next, the protection layer may be formed on the initial passivation layer 116a. A part of the protection layer 117 formed in the area between the plurality of sub pixels SP and a part of the protection layer 117 overlapping the second reflective electrode RE2 in the contact area CA are etched to form the protection layer 117. The contact hole formed in the protection layer 117 in the contact area CA may be larger than the contact hole of the second planarization layer 115. An end portion of the protection layer 117 in the contact area CA may be disposed on the top surface of the second planarization layer 115. A part of the initial passivation layer 116a which covers a top surface of the light emitting diode ED in each of the plurality of sub pixels SP may be exposed from the protection layer 117. An ashing process is performed to expose a part of the initial passivation layer 116a from the protection layer 117 to control a thickness of the protection layer 117.

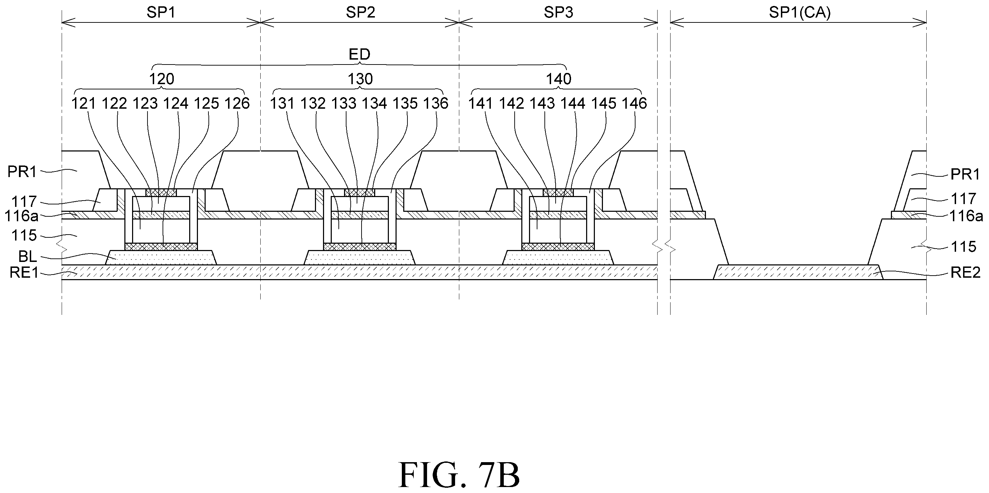

As shown in FIG. 7B, a primary etching process is performed to etch a part of the initial passivation layer 116a by forming a first photo resist PR1.

The initial passivation layer 116a may be exposed from the protection layer 117 in an area between the plurality of sub pixels SP and in the contact area CA. The first photo resist PR1 may be disposed so as to cover a remaining part excluding a part of the initial passivation layer 116a exposed from the protection layer 117 and to be primarily etched. For example, the first photo resist PR1 may cover the initial passivation layer 116a exposed from the protection layer 117 in an area between the plurality of sub pixels SP which is an area where the undercut structure UC will be formed. The first photo resist PR1 may be disposed so as to cover a lateral end portion of the protection layer 117 in the contact area CA. Therefore, of the initial passivation layer 116a exposed from the protection layer 117, only a part of the initial passivation layer 116a covering an upper portion of the light emitting diode ED and a part of the initial passivation layer 116a covering the second reflective electrode RE2 may be exposed from the first photo resist PR1.

Next, a part of the initial passivation layer 116a exposed from the first photo resist PR1 is etched to be removed. For example, in the contact area CA, the portion of the initial passivation layer 116a covering the second reflective electrode RE2 is exposed from the first photo resist PR1, and an etching process to remove the portion of the initial passivation layer 116a covering the second reflective electrode RE2 may be performed using an etchant. For example, a part of the initial passivation layer 116a covering an upper portion of the plurality of light emitting diodes ED is exposed from the first photo resist PR1 to be removed during the primary etching process. Accordingly, the portion of the initial passivation layer 116a covering a p-type electrode of the light emitting diode ED and the portion of the initial passivation layer 116a covering the second reflective electrode RE2 are removed during the primary etching process. Therefore, the p-type electrode of the light emitting diode ED and the second reflective electrode RE2 may be exposed.

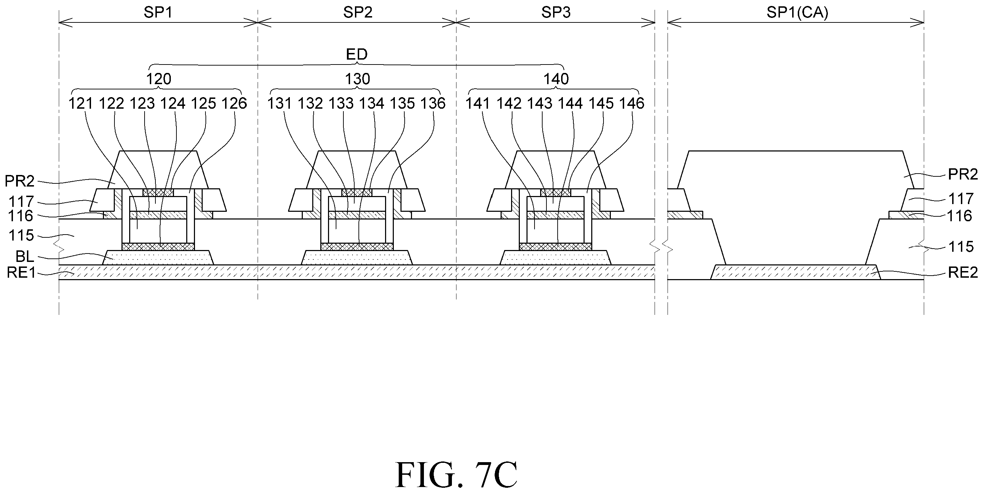

As illustrated in FIG. 7C, a secondary etching process is performed to etch other parts of the initial passivation layer 116a by removing the first photo resist PR1 and forming a second photo resist PR2.

The second photo resist PR2 may be disposed so as to cover the light emitting diode ED and the second reflective electrode RE2 in the contact area CA. For example, the second photo resist PR2 may be disposed so as to cover a top surface of the light emitting diode ED, an end portion of the initial passivation layer 116a which is in contact with a side surface of the light emitting diode ED, and a part of a top surface of the protection layer 117 in each of the plurality of sub pixels SP. A lateral end portion of the protection layer 117, which is a side surface of the protection layer 117, may be exposed from the second photo resist PR2 in an area between the plurality of sub pixels SP. The second photo resist PR2 may be disposed so as to cover an entire top surface of the second reflective electrode RE2, a lateral end portion of the second planarization layer 115, a lateral end portion of the initial passivation layer 116a, and a lateral end portion of the protection layer 117 in the contact area CA. Therefore, a part of the initial passivation layer 116a disposed in an area between the plurality of sub pixels SP, that is, an area in which the undercut structure UC is to be formed, may be exposed from the second photo resist PR2.

Next, a part of the initial passivation layer 116a exposed from the second photo resist PR2 is etched to form the passivation layer 116. For example, a part of the initial passivation layer 116a between the plurality of sub pixels SP is exposed from the second photo resist PR2 to be removed during the secondary etching process. At this time, over-etching may be induced to etch a part of the initial passivation layer 116a below the protection layer 117 by controlling an etching process condition, for example, a process time or a material of an etchant. For example, during the secondary etching process, a part of the initial passivation layer 116a exposed from the protection layer 117 is etched first in an area between the plurality of sub pixels SP. Thereafter, the other part of the initial passivation layer 116a formed between protection layer 117 and the second planarization layer 115 may be sequentially etched. Therefore, the secondary etching process to etch the initial passivation layer 116a disposed in the area between the plurality of sub pixels SP is performed to allow the lateral end portion of the passivation layer 116 to be located farther inside toward the middle of the corresponding sub pixel SP than the end portion of the protection layer 117. By doing this, an undercut structure UC between the passivation layer 116 and the protection layer 117 may be formed.

Here, in the primary etching process and the secondary etching process, the first photo resist PR1 and the second photo resist PR2 are disposed so as to cover the lateral end portion of the protection layer 117 in the contact area CA so as not to form the undercut structure UC in the contact area CA. During the primary etching process, the first photo resist PR1 is disposed so as to cover the lateral end portion of the protection layer 117 in the contact area CA so that the lateral end portion of the passivation layer 116 is disposed in an area closer to the center of the contact area CA than the lateral end portion of the protection layer 117 is. For example, during the primary etching process of the initial passivation layer 116a, a part overlapping the first photo resist PR1 is not removed, but only a part not overlapping the first photo resist PR1 may be removed. Accordingly, the first photo resist PR1 is disposed so as to cover the lateral end portion of the protection layer 117 in the contact area CA so that the end portion of the passivation layer 116 may extend farther from the lateral end portion of the protection layer 117.

During the secondary etching process, the second photo resist PR2 is disposed so as to cover the end portion of the protection layer 117 in the contact area CA so that the lateral end portion of the passivation layer 116 exposed from the protection layer 117 may be protected so as not to be etched. If the second photo resist PR2 is not formed in the contact area CA, the etching would be performed from the lateral end portion of the passivation layer 116 exposed from the protection layer 117 to the part of the passivation layer 116 disposed below the protection layer 117. Therefore, an undercut structure UC may be formed between the protection layer 117 and the passivation layer 116. In this case, the pixel electrode PE extending from the second reflective electrode RE2 toward the light emitting diode ED may be disconnected in the contact area CA. Therefore, in the primary etching process and the secondary etching process, the first photo resist PR1 and the second photo resist PR2 are disposed so as to cover the lateral end portion of the protection layer 117 in the contact area CA. Therefore, the undercut structure UC may be not formed in the area between the light emitting diodes ED in the contact area CA.

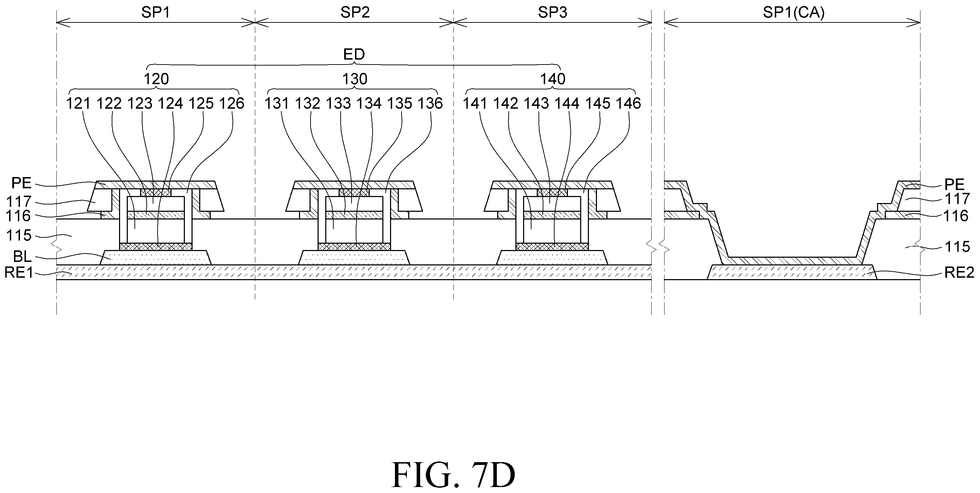

As shown in FIG. 7D, the second photo resist PR2 is removed, and the pixel electrode PE is formed. A pixel electrode PE connecting the second reflective electrode RE2 in the contact area CA with the light emitting diode ED may be formed in each of the plurality of sub pixels SP. The pixel electrode PE may be in contact with the p-type electrode (e.g., 125, 135, 145) of the light emitting diode ED and the second reflective electrode RE2 exposed from the passivation layer 116 in the primary etching process.

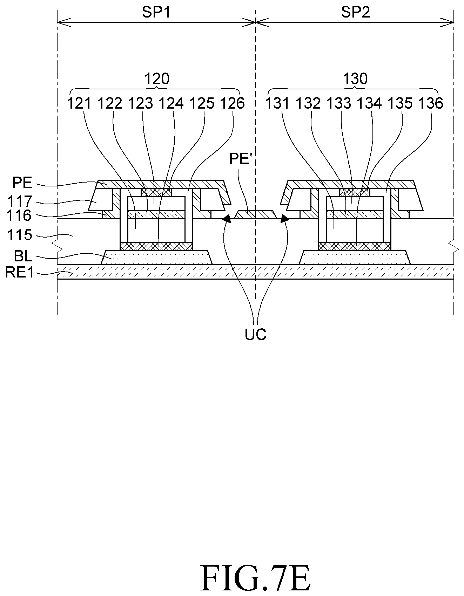

Here, as illustrated in FIG. 7E, when the pixel electrode PE is formed in each of the plurality of sub pixels SP, a patterning defect of the plurality of pixel electrodes PE may be caused due to the process error or defect. For example, a material forming the pixel electrode PE is formed on the front surface (or the upper surface in the cross-sectional views) of the substrate 110 and is patterned to form the plurality of pixel electrodes PE. However, the material of the pixel electrode PE formed in the area between the plurality of sub pixels SP is to be patterned, and there may be a patterning defect whereby the material of the pixel electrode PE disposed in the area between some of the sub pixels SP is not properly removed due to a process defect. If the pixel electrodes PE of the first sub pixel SP1 and the second sub pixel SP2 are connected to each other due to such a patterning defect, a short-circuit defect may occur.

Therefore, in the display device 100 according to example embodiments of the present disclosure, the undercut structure UC is formed in the area between the plurality of sub pixels SP to minimize or suppress a short-circuit defect that may be caused by the patterning defect of the pixel electrode PE. For example, a pixel electrode remaining film PE' disposed in the area between the first sub pixel SP1 and the second sub pixel SP2 is intended to be patterned in the formation process of the pixel electrode PE, but there may be a defect whereby the pixel electrode remaining film PE' is not properly removed due to a process defect. Here, in the undercut structure UC of the first sub pixel SP1, the pixel electrode PE of the first sub pixel SP1 and the pixel electrode remaining film PE' may be separated from each other. Further, in the undercut structure UC of the second sub pixel SP2, the pixel electrode PE of the second sub pixel SP2 may be separated and disconnected from the pixel electrode remaining film PE'. In other words, the pixel electrode PE and the pixel electrode remaining film PE' may be separated from each other in the plurality of disconnection structures disposed on both sides of the plurality of light emitting diodes ED. Accordingly, even if the patterning defect occurs, the pixel electrode remaining film PE' and the pixel electrode PE would be disconnected in the undercut structure UC to suppress a short-circuit defect of the pixel electrodes PE of different sub pixels SP being connected to teach other.

The example embodiments of the present disclosure can also be described as follows:
According to an aspect of the present disclosure, a display device includes a display panel including a plurality of sub pixels; a light emitting diode disposed in each of the plurality of sub pixels; a passivation layer covering, at least partially, a side portion of the light emitting diode; a protection layer disposed on the passivation layer and covering, at least partially, the side portion of the light emitting diode; and a pixel electrode disposed on the light emitting diode and the protection layer, wherein in a boundary area between two adjacent sub pixels in a first direction, among the plurality of sub pixels, a lateral end of the passivation layer is disposed under the protection layer to form an undercut structure under the protection layer.

In some example embodiments, a lateral end of the protection layer may protrude from the lateral end of the passivation layer in the first direction in the boundary area between the two adjacent sub pixels.

In some example embodiments, the undercut structure is disposed between the respective pixel electrodes of the two adjacent sub pixels.

In some example embodiments, a top surface of the light emitting diode may be exposed from the passivation layer and the protection layer and may be connected to the pixel electrode.

In some example embodiments, the display device may further include a planarization layer covering a part of the side portion of the light emitting diode below the passivation layer. A top surface of the planarization layer may be disposed below a top surface of the light emitting diode, and the lateral end of the passivation layer may be disposed on the top surface of the planarization layer

In some example embodiments, the display device may further include a first reflective electrode disposed below and connected to the light emitting diode in each of the plurality of sub pixels; a second reflective electrode spaced apart from the first reflective electrode in a second direction in each of the plurality of sub pixels, the second direction crossing the first direction; a power line electrically connected to the first reflective electrode; and a driving transistor disposed in each of the plurality of sub pixels and electrically connected to the second reflective electrode. The pixel electrode may extend in the second direction between the second reflective electrode and the light emitting diode and may electrically connect the second reflective electrode and the light emitting diode with each other.

In some example embodiments, the pixel electrode may be connected to the second reflective electrode via a contact hole through the passivation layer and the protection layer in a contact area, and no undercut structure may be formed in the passivation layer under the protection layer adjacent to the contact hole.

In some example embodiments, the pixel electrode may be connected to the second reflective electrode via a contact hole through the passivation layer and the protection layer in a contact area, and another lateral end of the passivation layer adjacent to the contact hole may extend farther toward a center of the contact hole than a lateral end of the protection layer does.

According to another example of the present disclosure, a display device includes a substrate; at least one first reflective electrode disposed on the substrate; a plurality of second reflective electrodes on the substrate and spaced apart respectively from the at least one first reflective electrode; a plurality of light emitting diodes disposed respectively on the at least one first reflective electrode; a planarization layer on the at least one first reflective electrode and the second reflective electrodes to cover lower portions of the plurality of light emitting diodes; a plurality of disconnection structures on the planarization layer and disposed respectively at both lateral sides of the plurality of light emitting diodes in a first direction; and a plurality of pixel electrodes on and in contact with the plurality of light emitting diodes, respectively, wherein the plurality of disconnection structures is disposed respectively between the plurality of pixel electrodes in the first direction.

In some example embodiments, each of the plurality of disconnection structures may include a passivation layer at least partly covering a side surface of a corresponding one of the plurality of light emitting diodes; and a protection layer at least partially covering the passivation layer. The protection layer may have a lateral end protruding in the first direction from a lateral end of the passivation layer.

In some example embodiments, each of the plurality of disconnection structures may be an undercut structure between the lateral end of the protection layer and the lateral end of the passivation layer.

In some example embodiments, the plurality of disconnection structures and the plurality of pixel electrodes may be parallel with one another.

In some example embodiments, the plurality of disconnection structures may overlap the at least one first reflective electrode, respectively, without overlapping the plurality of second reflective electrodes.

In yet another example of the present disclosure, a display device includes a display panel including a plurality of sub pixels, each of the plurality of sub pixels including a light emitting diode on a substrate; a passivation layer on the substrate and at least partly covering a lateral side surface of the light emitting diode; and a protection layer on the passivation layer and at least partly covering a lateral side surface of the passivation layer, wherein a lateral end of the passivation layer in a first direction is disposed under the protection layer to form an undercut structure under the protection layer.

In some example embodiments, each of the plurality of sub pixels may further include a pixel electrode on the light emitting diode and the protection layer.

In some example embodiments, each of the sub pixels may further include a driving transistor between the substrate and the passivation layer; the pixel electrode may extend in a second direction from the light emitting diode to a contact area, the second direction crossing the first direction; the pixel electrode may be electrically connected to the driving transistor via a contact hole through the protection layer and the passivation layer in the contact area; and the passivation layer may not have an undercut structure under the protection layer adjacent to the contact area.

In some example embodiments, each of the plurality of sub pixels may further include a first reflective electrode under the light emitting diode, the first reflective electrode being electrically connected between a power line and the light emitting diode; and a second reflective electrode spaced apart from the first reflective electrode in the second direction, the second reflective electrode being disposed in the contact area and electrically connected between the light emitting diode and the driving transistor.

In some example embodiments, a lateral end of the protection layer may extend farther in a first direction toward a boundary between two adjacent sub pixels in the first direction, among the plurality of sub pixels, than the lateral end of the passivation layer does.

In some example embodiments, the display device may further include a bank at the boundary between the two adjacent sub pixels, the bank having a portion disposed under the lateral end of the protection layer to fill an area of the undercut structure.

In some example embodiments, the bank may be disposed between the respective pixel electrodes of the two adjacent sub pixels and may cover a side surface of the protection layer; and the bank may separate the respective pixel electrodes of the two adjacent sub pixels from each other.

Although various example embodiments of the present disclosure have been described in detail with reference to the accompanying drawings, the present disclosure is not limited thereto and may be embodied in many different forms without departing from the technical concept of the present disclosure. Therefore, the above example embodiments of the present disclosure are provided for illustrative purposes only and are not intended to limit the technical concept of the present disclosure. The scope of the technical concept of the present disclosure is not limited thereto. Therefore, it should be understood that the above-described example embodiments are illustrative in all aspects and do not limit the present disclosure. All the technical concepts in the equivalent scope of the present disclosure should be construed as falling within the scope of the present disclosure.

## Claims

1. A display device, comprising:
a display panel including a plurality of sub pixels;
a light emitting diode disposed in each of the plurality of sub pixels;
a passivation layer covering, at least partially, a side portion of the light emitting diode;
a protection layer disposed on the passivation layer and covering, at least partially, the side portion of the light emitting diode; and
a pixel electrode disposed on the light emitting diode and the protection layer,
wherein in a boundary area between two adjacent sub pixels in a first direction, among the plurality of sub pixels, a lateral end of the passivation layer is disposed under the protection layer to form an undercut structure under the protection layer.

2. **The** display device of claim 1, wherein a lateral end of the protection layer protrudes from the lateral end of the passivation layer in the first direction in the boundary area between the two adjacent sub pixels.

3. **The** display device of claim 1 or 2, wherein the undercut structure is disposed between the respective pixel electrodes of the two adjacent sub pixels.

4. **The** display device of any preceding claim, wherein a top surface of the light emitting diode is exposed from the passivation layer and the protection layer and is connected to the pixel electrode.

5. **The** display device of any preceding claim, further comprising:
a planarization layer covering a part of the side portion of the light emitting diode below the passivation layer,
wherein a top surface of the planarization layer is disposed below a top surface of the light emitting diode, and the lateral end of the passivation layer is disposed on the top surface of the planarization layer.

6. **The** display device of any preceding claim, further comprising:
a first reflective electrode disposed below and connected to the light emitting diode in each of the plurality of sub pixels;
a second reflective electrode spaced apart from the first reflective electrode in a second direction in each of the plurality of sub pixels, the second direction crossing the first direction;
a power line electrically connected to the first reflective electrode; and
a driving transistor disposed in each of the plurality of sub pixels and electrically connected to the second reflective electrode,
wherein the pixel electrode extends in the second direction between the second reflective electrode and the light emitting diode and electrically connects the second reflective electrode and the light emitting diode with each other.

7. **The** display device of claim 6, wherein:
the pixel electrode is connected to the second reflective electrode via a contact hole through the passivation layer and the protection layer in a contact area; and
no undercut structure is formed in the passivation layer under the protection layer adjacent to the contact hole.

8. **The** display device according to claim 6, wherein:
the pixel electrode is connected to the second reflective electrode via a contact hole through the passivation layer and the protection layer in a contact area; and
another lateral end of the passivation layer adjacent to the contact hole extends farther toward a center of the contact hole than a lateral end of the protection layer does.
